# EUROPEAN PATENT APPLICATION

(11) **EP 1 619 268 A2**
(43) Date of publication of application: **25.01.2006**
(21) Application number: 05015784.1
(22) Date of filing: 20.07.2005
(51) Int. Cl.: C23C 16/44, B08B 7/00, H01L 21/00, C23F 1/12

(54) **Process for titanium nitride removal**

(30) Priority: 22.07.2004 US 896588
(71) Applicant: AIR PRODUCTS AND CHEMICALS, INC., Allentown, PA 18195-1501 (US)
(72) Inventor: Dingjun, Wu, Macungie PA 18062 (US); Bing, Ji, Allentown PA 18104 (US); Karwacki, Eugene Joseph Jr, Orefield PA 18069 (US)
(74) Representative: Kador, Ulrich

(57) **Abstract**

A process of removing titanium nitride from a surface of a substrate includes: providing a process gas including at least one reactant selected from the group consisting of a fluorine-containing substance and a chlorine-containing substance; enriching the process gas with at least one reactive species of the at least one reactant to form an enriched process gas, wherein the enriching is conducted at a first location; providing the substrate at a substrate temperature greater than 50°C, wherein the surface of the substrate is at least partially coated with the titanium nitride; and contacting the titanium nitride on the surface of the substrate with the enriched process gas to volatilize and remove the titanium nitride from the surface of the substrate, wherein the contacting occurs at a second location differing from the first location.

## Description

### BACKGROUND OF THE INVENTION

Titanium nitride is commonly used as a diffusion barrier in integrated circuitry, serving to prevent the diffusion or migration of conductive materials into insulating materials and active regions of transistors. It also serves as an adhesion promoter that eliminates delamination and voids between the conductive materials and the surrounding region of insulating, dielectric materials. During the deposition of TiN residues containing the final material as well as the reactants deposit along the inner walls and onto the surfaces of components within the reactor. To mitigate particle creation from the buildup of these residues, the chamber and components within the reactor must be periodically cleaned. Therefore, an effective method for such titanium nitride removal is needed.

In addition to having utility in semiconductor manufacturing, titanium nitride is often used as a coating in aerospace and automotive applications. The reactors used to deposit titanium nitride films must be cleaned on a regular schedule to insure process uniformity. As a result, there is a need for a quick and economic means to clean these reactors.

Titanium nitride is also used to coat various machine parts. Occasionally, during or following the coating process, the coating spalls or lacks the desired uniformity required for the part. Oftentimes such "failed" parts must be discarded or sold as defective parts at a lower price. If the coating could be removed from the part without damaging the underlying surface or morphology of the part, it could then be recoated and utilized as a "prime" component.

Currently, mechanical means, such as scrubbing or blasting, or wet chemical solutions are commonly used to clean titanium nitride processing chambers and any parts taken from the chambers.

Compared with wet or mechanical cleaning, reactive gas cleaning preserves reactor vacuum and, as a result, can greatly minimize chamber down time and increase wafer throughput. Although aspects of reactive gas cleaning methods are known to be useful in other contexts, such methods have not been completely satisfactory for the removal of titanium nitride from surfaces. For example, U.S. Pat. No. 5,948,702, which teaches a dry etch method for removing titanium nitride films from W/TiN gate structures by using a remote plasma to excite a source gas mixture which contains oxygen and fluorine such as C₂F₆ and O₂, discloses a titanium nitride etch rate not higher than about 110 nm/min.

The use of an elevated substrate temperature has been suggested to either increase titanium nitride etch selectivity over other materials or to increase titanium nitride etch rate. See, e.g., U.S. Pat. No. 5,419,805, which discloses a method of selectively etching a layer of refractory metal nitride relative to an underlying layer of refractory metal silicide, where the substrate is first heated to 50 to 200°C, then exposed to a plasma generated from a halocarbon feed gas, such as CF₄, C₂F₆, and CHF₃; and U.S. Pat. No. 6,177,355 B1, which teaches a method of pad etching to remove anti-reflective coating over a conductor in an integrated circuit, where a high temperature etch is generated by, for example, turning off the backside helium cooling of the RF powered electrode. Despite the use of elevated temperatures, the etch rates achieved by these methods leave room for improvement.

A method for cleaning films from processing chambers is discussed in Japanese Pat. No. 2,833,684 B2. This patent discloses a method of cleaning deposits of chemicals, including titanium nitride, that appear in thin film processing equipment. Specifically, the patent teaches a method of adding fluorine to nitrogen trifluoride at a temperature between 150 and 600°C. This patent does not teach the use of plasma, instead using only thermal heating.

References teaching plasma etching of titanium nitride using in-situ plasma include WO 98/42020 A1, WO 00/19491 and WO 02/013241 A2. The process gases can be either Cl-containing or F-containing substances, such as Cl₂, HCl, BCl₃, CF₄, SF₆, CHF₃, or NF₃.

WO 00/19491 teaches the use of elevated temperatures in the context of cleaning a titanium nitride deposition chamber. The application focuses on the in-situ cleaning of a processing chamber by introducing chlorine gas into the chamber at an elevated temperature, with or without the use of in-situ plasma activation. The temperatures taught in this application, which are as high as 500-700°C, significantly increase the thermal budget and increase the cost of ownership for the processing chambers.

Therefore, it is desired to provide a method to remove titanium nitride from surfaces, such as the surfaces of processing chambers or parts, at a high etch rate. Further, it is desired to provide a method that accomplishes such removal without damaging the surface of chambers or parts. It is further desired to provide a reactive gas method for removing titanium nitride from surfaces, which is efficient and effective.

All references cited herein are incorporated herein by reference in their entireties.

### BRIEF SUMMARY OF THE INVENTION

In one aspect of the invention, there is provided a process of removing titanium nitride from a surface of a substrate comprising: providing a process gas including at least one reactant selected from the group consisting of a fluorine-containing substance and a chlorine-containing substance; enriching the process gas with at least one reactive species of the at least one reactant to form an enriched process gas, wherein the enriching is conducted at a first location; providing the substrate at a substrate temperature greater than 50°C, wherein the surface of the substrate is at least partially coated with the titanium nitride; and contacting the titanium nitride on the surface of the substrate with the enriched process gas to volatilize and remove the titanium nitride from the surface of the substrate, wherein the contacting occurs at a second location differing from the first location.

Further provided is a process of removing titanium nitride from a surface of a substrate comprising: providing a process gas comprising at least one reactant selected from the group consisting of a fluorine-containing substance and a chlorine-containing substance; enriching the process gas with at least one reactive species of the at least one reactant to form an enriched process gas; providing the substrate at a substrate temperature from 50°C to 900°C, wherein the surface of the substrate is at least partially coated with the titanium nitride; and contacting the titanium nitride on the surface of the substrate with the enriched process gas to volatilize and remove the titanium nitride from the surface of the substrate at an etch rate greater than 180 nm/min, wherein the enriched process gas contacting the titanium nitride is substantially free of ions.

Still further provided is a process of removing a coating from a surface of a substrate comprising: providing a process gas comprising at least one reactant selected from the group consisting of a fluorine-containing substance and a chlorine-containing substance; enriching the process gas with at least one reactive species of the at least one reactant to form an enriched process gas, wherein the enriching is conducted at a first location; providing the substrate at a substrate temperature from 50°C to 900°C; and contacting the coating on the surface of the substrate with the enriched process gas to volatilize and remove the coating from the surface of the substrate at an etch rate greater than 180 nm/min, wherein the contacting occurs at a second location differing from the first location, and the coating on the surface of the substrate comprises a binary compound of titanium and nitrogen.

Still further provided is an apparatus for performing the inventive process, said apparatus comprising: a cleaning process reactor separate from a process reactor; a remote plasma generator; a gas distributor adapted to provide a flow of gas throughout the cleaning process reactor; a heating device; and a pumping system adapted to remove reactive gases and volatile products from the cleaning process reactor.

### BRIEF DESCRIPTION OF SEVERAL VIEWS OF THE DRAWINGS

Certain aspects of the invention will be described in conjunction with the following drawings in which like reference numerals designate like elements and wherein:

Fig. 1 is a schematic diagram of an experimental system used in the Examples.

Fig. 2 is a graph of etch rate versus substrate temperature for Example 1.

Fig. 3 is a graph of etch rate versus substrate temperature for Example 4.

### DETAILED DESCRIPTION OF THE INVENTION

A process for removing titanium nitride from the surface of a substrate using reactive gas cleaning is described herein. A requirement for reactive gas cleaning is to convert a solid non-volatile material into volatile species that can be removed (e.g., by a vacuum pump). In addition to being thermodynamically favorable, the chemical reactions for the conversion should also be kinetically feasible. Due to the chemical inertness of titanium nitride, an external energy source to overcome an activation energy barrier is needed so that the reaction can proceed. The external energy source is preferably provided in the form of thermal activation. The relatively high temperatures involved in thermal activation can accelerate chemical reactions, and make reaction byproducts more volatile. However, there may be practical limitations on temperature in production chambers.

The inventors have discovered that the temperature of thermal activation need not be unduly high when the process gas has been treated to contain an enhanced concentration of reactive species. The combination of thermal activation and reactive species enrichment of the process gas provides a more effective and efficient method of removing titanium nitride from a substrate surface than does thermal activation alone.

Thus, a thermally activated substrate is contacted with a process gas to volatilize titanium nitride deposited on the surface of the substrate. The process gas is treated so as to provide (or increase the occurrence of) reactive species therein. A "reactive species" as used herein denotes radicals capable of reacting with titanium nitride to form a volatile product. Fluorine and chlorine radicals are particularly preferred examples of reactive species.

A remote plasma generator is the most preferred means of enriching the process gas with reactive species. However, the invention is not limited thereto. Other means for increasing the concentration of reactive radicals in the process gas, such as heating the process gas in a remote furnace, and dissociating the process gas by UV radiation, etc. are also within the scope of the invention.

Although an in-situ plasma generator as well as a remote plasma generator can provide reactive species, in-situ plasma activation can also cause undesirable side effects. The use of in-situ plasma can result in damage to the substrate because of ion bombardment. Unlike in-situ plasmas, remote plasmas can generate reactive species to facilitate titanium nitride removal without damage to the substrates caused by ion bombardment. Undamaged substrates are evidence that the ions present in the remote plasma generator are neutralized in transit from the remote plasma generator to the reactor containing the substrate surface to be cleaned. Thus, the process gas is substantially free of ions when the titanium nitride is removed from the substrate without damaging the substrate. The process gas is substantially free of ions when the concentration of ions is less than 10⁶ cm⁻³.

In addition, a remote plasma unit can more easily be retrofit into an existing system. Thus, it is preferable to use a remote plasma generator when using reactive gas to clean deposition chambers. Such embodiments enable some or all of the titanium nitride to be removed from the substrate without damaging the substrate by ion bombardment.

Examples of suitable plasma generators include, but are not limited to, a microwave plasma generator and an RF plasma generator.

The process gas comprises at least one reactive gas, and optionally at least one carrier gas. The reactive gas contains at least one reactant capable of reacting with (or capable of forming a species reactive with) titanium nitride to form a volatile product. Fluorine- and/or chlorine-containing substances are preferred reactants, with fluorine-containing substances being more preferred.

Non-limiting examples of fluorine-containing reactive gases include: NF₃ (nitrogen trifluoride), NClₓF₃₋ₓ, with x = 1-2, F₂ (elemental fluorine), CIF₃ (chlorine trifluoride), CIF (chlorine monofluoride), SF₆ (sulfur hexafluoride), BrF₃ (bromine trifluoride), BF₃ (boron trifluoride), perfluorocarbons such as CF₄ and C₂F₆, etc., hydrofluorocarbons such as CHF₃ and C₃F₇H, etc., oxyfluorocarbons such as C₄F₈O (perfluorotetrahydrofuran), CF₃OF (fluoroxytrifluoromethane), CF₃OOCF₃ (bistrifluoromethane peroxide), and COF₂, etc. The fluorine-containing reactive gases can be delivered by a variety of means, such as conventional cylinders, safe delivery systems, vacuum delivery systems, and solid or liquid-based generators that create the reactive gas at the point of use.

Non-limiting examples of chlorine-containing reactive gases include BCl₃ (boron trichloride), Cl₂ (chlorine), COCl₂ (phosgene), HCl (hydrogen chloride), and trans-dichloroethylene (C₂H₂Cl₂) (e.g., TRANS-LC available from Air Products and Chemicals, Inc., Allentown, PA).

The process gas is preferably supplied to the plasma reactor at a flow rate of 10 to 10,000 sccm.

The process gas can optionally include at least one carrier gas. Suitable carrier gases include, but are not limited to, N₂, He, Ne, Kr, Xe and/or Ar. The carrier gas can constitute 0 to at least 99.9% of the processing gas, more preferably 1 to 99.9% of the processing gas.

The process gas can optionally include additional additives, provided that they do not unduly hinder the effectiveness of the process. For example, oxygen gas may be useful in certain embodiments to assist with dissociation of the reactive gas to form reactive species, but may be not useful in other embodiments.

As discussed above, the preferred means for enriching the process gas with reactive species is to generate plasma from the process gas in a remote plasma generator. The term "plasma" as used herein denotes a gas containing ions and electrons. The plasma is generated from the process gas in a remote plasma generator to provide an enriched process gas, and the enriched process gas is conveyed to the reactor, wherein the reactive species in the process gas react with titanium nitride in the reactor. The reaction product is volatile and is carried away from the substrate by the gas flow through the reactor.

Conditions suitable for generating plasma from the process gas are not particularly limited. Preferred plasma generation parameters are as follows: a plasma pressure of 0.5 to 50 Torr and a plasma power of 100 to 10,000 Watts. More preferred plasma generation parameters are as follows: a plasma pressure of 1 to 10 Torr and a plasma power of 500 to 5,000 Watts.

In preferred embodiments, the enriched process gas is conveyed from a remote plasma generator (a "first location") to the reactor (a "second location") containing the substrate from which titanium nitride is to be removed. The enriched process gas may be conveyed with the assistance of an optional carrier gas and/or a pressure differential between the first and the second location. Conditions in the reactor are selected to facilitate the reaction between the reactive gas(es) of the plasma and the titanium nitride on the substrate. The reactor pressure is preferably 0.5 to 50 Torr, more preferably 1 to 10 Torr. The reactor pressure can be the same as or different from the plasma pressure. The reactor temperature is not particularly limited.

The substrate is contained within the reactor, and in some embodiments, can be a surface of the reactor itself. In other embodiments, the substrate is an object within the reactor that is distinct from the reactor. Thus, suitable substrates having surfaces from which titanium nitride can be removed include, but are not limited to, processing chambers, tool parts, machine parts, workpieces, etc.

The substrate is heated to a substrate temperature that combines with the reactive species in the enriched process gas to facilitate removal of the titanium nitride from the surface of the substrate. A suitable substrate temperature range depends on the thermal decomposition temperature of the reactive gas, the energy needed to overcome the reaction activation energy barrier, and the equipment hardware capabilities. Substrate temperatures suitable for thermal activation when used in combination with reactive species enrichment are preferably 50°C or greater, preferably from 50 to 900°C, more preferably from 50 to 500°C, and even more preferably from 100 to 350°C.

The means for heating the substrate are not particularly limited. In certain embodiments, the substrate is in thermal contact with a heating device. Preferably, the substrate is mounted on a pedestal heater at a position accessible to the enriched process gas. In other embodiments, the temperature of the reactor is raised to heat the substrate by use of external heating elements, such as lamps or resistive heaters. For example, when the substrate is a surface of the reactor itself, the temperature of the reactor is raised (and the substrate temperature is the same as the reactor temperature).

The process described herein is capable of etching titanium nitride from the surface of a substrate at high rates without damaging the substrate. The expression "titanium nitride" is used herein in accordance with its conventional meaning to denote binary compounds of titanium and nitrogen in a wide range of stoichiometric ratios.

Certain embodiments of the invention provide faster etch rates than others. For example, an etch rate of over 240 nm/min is achieved using a remote NF₃ plasma and a thermal heating of 100°C, while an etch rate of about 6 nm/min is achieved using remote Cl₂ plasma and a thermal heating of 350°C. The process described herein may etch titanium nitride at a rate of at least about 6 nm/min, preferably at least about 40 nm/min, more preferably greater than 180 nm/min, and still more preferably greater than 240 nm/min.

In certain embodiments of the invention, parts are cleaned in a reactor separate from the process reactor in which the parts were coated with titanium nitride. A preferred apparatus suitable for this separate cleaning process comprises a cleaning process reactor equipped with a remote plasma generation system, a gas distributor for assuring uniform flow of gas throughout the cleaning process reactor, a means to heat the reactor, and a pumping system for removing reactive gases and volatile products from the cleaning process reactor. Components, such as reactor parts and tool bits, coated with TiN are loaded into the reactor. Upon reaching the desired process temperature, the flow of reactive gas is initiated through the remote plasma unit. Fluorine and/or chlorine radicals created by the plasma then flow through the distributor plate and into the process chamber. TiN is removed from the parts placed into the reactor leaving the substrates free of the deposit.

### EXAMPLES

The invention will be illustrated in more detail with reference to the following Examples, but it should be understood that the present invention is not deemed to be limited thereto.

The following are experimental examples for titanium nitride removal using reactive gas cleaning. The experimental system has both remote plasma and thermal heating capabilities. In all experiments, samples were prepared from Si wafers coated with about 120 nm titanium nitride. The titanium nitride removal rate was calculated by the titanium nitride thin film thickness change before and after a timed exposure to the processing conditions. The titanium nitride thin film thickness was determined using a four-point electric conductivity probe. To verify the accuracy of the electrical four-point probe measurements, some of the sample coupons were cut into cross-sections after the etching/cleaning process. The coupon cross-sections were then examined by scanning electron microscopy (SEM) to accurately determine the titanium nitride film thickness after processing. The SEM results were consistent with the four-point probe measurements.

### Example 1: Removal of Titanium Nitride Using Combination of Remote NF₃ Plasma and Thermal Heating

This example demonstrates a method of cleaning processing chambers and parts by using a combination of remote plasma and thermal heating, with NF₃ as the process gas.

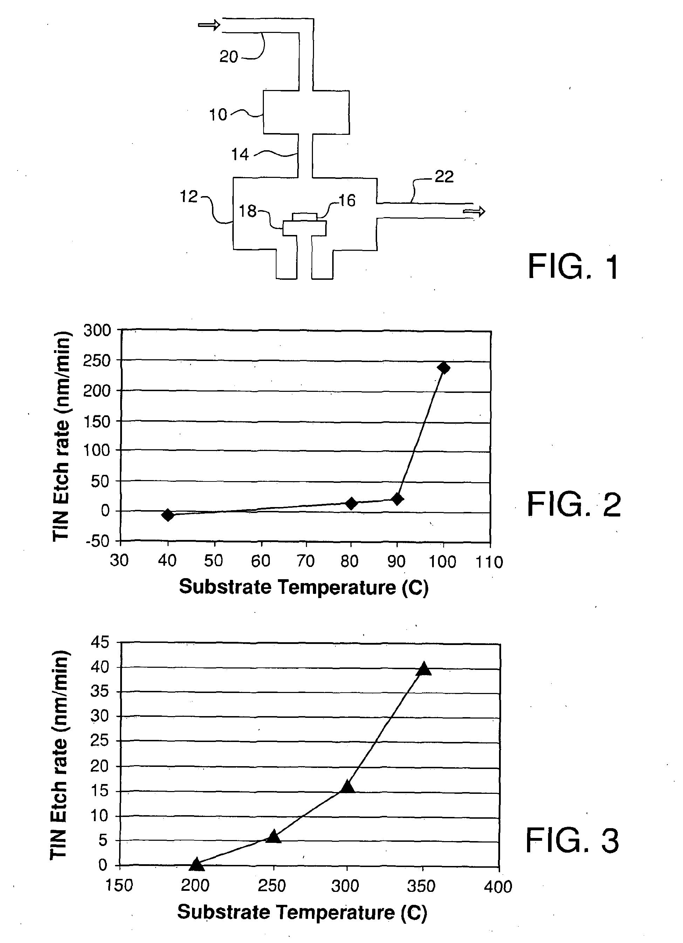

Figure 1 shows the schematic process diagram for the experimental system. Remote plasma generator 10 (an MKS ASTRON, available from MKS Instruments of Wilmington, MA) was mounted on top of reactor 12. The distance between exit 14 of plasma generator 10 and sample coupon 16 was approximately six inches (15.25 cm). Coupon 16 was placed on a surface of pedestal heater 18. The heater was used to obtain different substrate temperatures. In all of the runs, the remote plasma generator was operated with a mixture of 200 sccm NF₃ and 200 sccm Ar as process gases (fed to plasma generator 10 via pipe 20) and the chamber pressure was kept at 4 torr with the assistance of pump port 22.

The following experimental sequence was conducted for each design of experiments (DOE) run:
1. Vent chamber;
2. Load test coupons and close front door;
3. Evacuate chamber to reach baseline vacuum pressure;
4. Heat test coupons to a preset temperature;
5. After reaching the preset temperature, introduce Argon and stabilize pressure;
6. Turn on the remote plasma power;
7. Introduce process gases;
8. Turn off the remote plasma power after a preset time;
9. Stop process flows and evacuate chamber; and
10. Vent chamber and retrieve test coupons for analysis.

Figure 2 shows the titanium nitride etch rates at different substrate temperatures. At 40ºC, the thin film thickness was increased and, as a result, a negative etch rate is shown on Figure 2 at this temperature condition. At such low temperatures, the incorporation of fluorine atoms into the titanium nitride lattice structure on the sample surface could cause the thin film thickness increase.

Etching of titanium nitride was observed at temperatures above 40°C. The titanium nitride etch rate was increased with the increase of substrate temperature. Surprisingly, between 90ºC to 100ºC, the etch rate jumped suddenly by a factor greater than ten. Example 3 shows that the etch rate was only about 20 nm/min at 450ºC when only thermal heating was used. The results indicate that there is a synergistic interaction between the remote plasma and thermal heating.

Experimental data also indicate that the addition of O₂ to the process gas did not improve the cleaning process.

### Example 2: Removal of Titanium Nitride Using Combination of Remote Cl₂

### Plasma and Thermal Heating

This example demonstrates a method of cleaning processing chambers and parts by using a combination of remote plasma and thermal heating, with Cl₂ as the process gas.

The experimental setup is the same as that of Example 1.

The process gas here is a mixture of 200 sccm Cl₂ and 200 sccm Ar. Under the remote Cl₂ plasma, no etching was observed at 100ºC, while an etch rate of about 6 nm/min was obtained at 350ºC. The etch rate for Cl₂ gas is much slower than that of the NF₃ gas. According to CRC Handbook, TiCl₄ is the most volatile (with melting point 25ºC and boiling point 136ºC) among Ti (IV) halides. TiF₄ has a melting temperature of 284ºC and only sublimes at even higher temperature. Based on this information, chlorine-based reagents should be able to volatize titanium nitride easier than the fluorine-based reagents. The discovery that fluoro-reagents such as NF₃ remove titanium nitride faster than chloro-reagents such as Cl₂ in a process combining the plasma and thermal activation is unexpected.

### Example 3: Removal of Titanium Nitride Using Thermal Heating of NF₃

This comparative example demonstrates a method of cleaning processing chambers and parts by using thermal heating, with NF₃ as the process gas.

The experimental setup was the same as that of Examples 1 and 2, except that the remote plasma was turned off and a higher chamber pressure, 8 torr, was used.

A NF₃ flow of 500 sccm was used as the process gas. The etch rate of titanium nitride was about 0.6 nm/min and about 20 nm/min at 350ºC and 450ºC, respectively. Without remote plasma, for the same process gas, a much higher temperature is required for the removal of titanium nitride.

### Example 4: Removal of Titanium Nitride Using Thermal Heating of F₂

This comparative example demonstrates a method of cleaning processing chambers and parts by using thermal heating, with F₂ as the process gas.

Other than NF₃, 5.1 % F₂ in N₂ was also tested for the titanium nitride removal. A steady flow of 250 sccm was passed through the reactor chamber and the chamber was kept at a pressure of 8 torr. Figure 3 shows the change of titanium nitride etch rate with the substrate temperature. A higher substrate temperature resulted in a higher titanium nitride etch rate. Compared to NF₃, a lower substrate temperature was needed for 5.1% F₂ to start the cleaning reaction with titanium nitride.

### Example 5: Removal of Titanium Nitride Using Thermal Heating of Cl₂

This comparative example demonstrates a method of cleaning processing chambers and parts by using thermal heating, with Cl₂ as the process gas.

No etch was observed when the experimental conditions were a flow of 200 sccm Cl₂, chamber pressure of 8 torr, and a substrate temperature of 350ºC. When the temperature was increased to 450ºC, there was still a thin layer of titanium nitride residue left after 10 minutes of cleaning. This indicates that the etch rate at 450ºC was less than 12 nm/min, which is much less than that of NF₃ under a similar operation condition. F-containing compounds are more active on the removal of titanium nitride than the Cl-containing compounds.

### Example 6: Removal of Titanium Nitride from the Surface of a Pedestal Heater

A pedestal heater with a titanium nitride coated surface was tested using the same process as that in Example 1. A heater made of aluminum was removed from a titanium nitride processing chamber. The titanium nitride layer on the heater surface was about 20 µm. In this experiment, 400 sccm NF₃, 400 sccm Ar, and 4 torr chamber pressure were used as the remote plasma condition and 150ºC was used as the substrate temperature. Within 45 minutes, the titanium nitride layer was completely removed. No damage was observed on the heater surface.

While the invention has been described in detail and with reference to specific examples thereof, it will be apparent to one skilled in the art that various changes and modifications can be made therein without departing from the spirit and scope thereof.

## Claims

1. A process of removing titanium nitride from a surface of a substrate, said process comprising:
providing a process gas comprising at least one reactant selected from the group consisting of a fluorine-containing substance and a chlorine-containing substance;
enriching the process gas with at least one reactive species of the at least one reactant to form an enriched process gas, wherein the enriching is conducted at a first location;
providing the substrate at a substrate temperature greater than 50°C, wherein the surface of the substrate is at least partially coated with the titanium nitride; and
contacting the titanium nitride on the surface of the substrate with the enriched process gas to volatilize and remove the titanium nitride from the surface of the substrate, wherein the contacting occurs at a second location differing from the first location.

2. The process of claim 1, wherein the substrate is a processing chamber, a tool part, a machine part or a workpiece.

3. The process of claim 1, wherein the substrate is substantially unharmed by removal of the titanium nitride.

4. The process of claim 1, wherein the first location is a plasma generator, the enriching comprises generating plasma from the process gas, and the second location is a reactor in fluid communication with the plasma generator.

5. The process of claim 4, wherein the plasma is generated at a plasma pressure of 0.5 to 50 Torr.

6. The process of claim 4, wherein the plasma generator has a plasma power ranging from 100 to 10,000 Watts.

7. The process of claim 1, wherein the substrate temperature is greater than 90°C.

8. The process of claim 1, wherein the at least one reactant is at least one member selected from the group consisting of NF₃, NClF₂, NCl₂F, F₂, ClF₃, ClF, SF₆, BrF₃, BF₃, a perfluorocarbon, a hydrofluorocarbon, and an oxyfluorocarbon.

9. The process of claim 8, wherein the process gas further comprises a carrier gas selected from the group consisting of N₂, He, Ne, Kr, Xe and Ar.

10. The process of claim 9, wherein the process gas comprises 0.1 to 100% of the at least one reactant and 99.9 to 0% of the carrier gas.

11. The process of claim 1, wherein the titanium nitride is removed from the surface at an etch rate greater than 180 nm/min.

12. The process of claim 1, wherein the titanium nitride is removed from the surface at an etch rate greater than 240 nm/min.

13. The process of claim 1, wherein some or all of the titanium nitride is removed from the substrate without ion bombardment of the substrate.

14. The process of claim 1, wherein the at least one reactant comprises NF₃ gas.

15. The process of claim 1, wherein the at least one reactive species comprises a fluorine radical.

16. A process of removing titanium nitride from a surface of a substrate, said process comprising:
providing a process gas comprising at least one reactant selected from the group consisting of a fluorine-containing substance and a chlorine-containing substance;
enriching the process gas with at least one reactive species of the at least one reactant to form an enriched process gas;
providing the substrate at a substrate temperature from 50°C to 900°C, wherein the surface of the substrate is at least partially coated with the titanium nitride; and
contacting the titanium nitride on the surface of the substrate with the enriched process gas to volatilize and remove the titanium nitride from the surface of the substrate at an etch rate greater than 180 nm/min, wherein the enriched process gas contacting the titanium nitride is substantially free of ions.

17. The process of claim 16, wherein the enriching comprises generating plasma from the process gas, and the enriched process gas contacting the titanium nitride is not plasma.

18. A process of removing a coating from a surface of a substrate, said process comprising:
providing a process gas comprising at least one reactant selected from the group consisting of a fluorine-containing substance and a chlorine-containing substance;
enriching the process gas with at least one reactive species of the at least one reactant to form an enriched process gas, wherein the enriching is conducted at a first location;
providing the substrate at a substrate temperature from 50°C to 900°C; and
contacting the coating on the surface of the substrate with the enriched process gas to volatilize and remove the coating from the surface of the substrate at an etch rate greater than 180 nm/min, wherein the contacting occurs at a second location differing from the first location, and the coating on the surface of the substrate comprises a binary compound of titanium and nitrogen.

19. An apparatus for performing the process of claim 1, said apparatus comprising:
a cleaning process reactor separate from a process reactor;
a remote plasma generator;
a gas distributor adapted to provide a flow of gas throughout the cleaning process reactor;
a heating device; and
a pumping system adapted to remove reactive gases and volatile products from the cleaning process reactor.
